Europäisches Patentamt

(19) European Patent Office

Office européen des brevets

(11) Publication number: **0 133 010**

**B1**

(12) **EUROPEAN PATENT SPECIFICATION**

(45) Date of publication of patent specification: **26.09.90**

(21) Application number: **84305023.8**

(22) Date of filing: **24.07.84**

(51) Int. Cl.⁵: **H 05 K 3/46, H 05 K 3/12, H 01 L 23/52**

(54) **Multilayered ceramic circuit board.**

(30) Priority: **27.07.83 JP 135882/83**

(43) Date of publication of application:
**13.02.85 Bulletin 85/07**

(45) Publication of the grant of the patent:
**26.09.90 Bulletin 90/39**

(84) Designated Contracting States:
**DE FR GB**

(56) References cited:
**EP-A-0 011 406**
**DE-A-3 227 657**
**DE-A-3 324 933**
**US-A-3 450 545**

(73) Proprietor: **HITACHI, LTD.**
**6, Kanda Surugadai 4-chome**
**Chiyoda-ku, Tokyo 100 (JP)**

(72) Inventor: **Ushifusa, Nobuyuki**
**Yuho-ryo 6-20-3, Ayukawa-cho**
**Hitachi-shi Ibaraki-ken (JP)**
Inventor: **Ogihara, Satoru**
**1-15-7 Minamikouya-cho**
**Hitachi-shi Ibaraki-ken (JP)**
Inventor: **Noro, Takanobu**
**656 Katakura-cho Kanagawa-ku**
**Yokohama-shi Kanagawa-ken (JP)**

(74) Representative: **Paget, Hugh Charles Edward et al**
**MEWBURN ELLIS & CO. 2/3 Cursitor Street**
**London EC4A 1BQ (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# EP 0 133 010 B1

**Description**

The present invention relates to a multilayered ceramic circuit board for example a multilayered printed ceramic circuit board on which LSIs can be directly mounted.

Ceramic circuit boards are often used for the mounting of semiconductor elements, in line with the trend towards constructing electronic circuits in a highly integrated form. Alumina procelain has hitherto been chosen for the production of ceramic boards, in view of its thermal conductivity, mechanical strength and electrical insulation.

However, alumina ceramic materials have a dielectric constant (herein also referred to as specific inductive capacity) as large as about 9, which means that signal transmissions within electronic circuits is delayed, which is a disadvantage when transmitting signals at high speeds. Alumina ceramic materials are fired at temperatures of as high as 1500°C to 1650°C and only metal materials of a high melting point, such as tungsten, molybdenum or the like, can be used for forming wiring circuits simultaneously with the firing of the ceramic material. Tungsten and molybdenum are materials that are difficult to bake, and exhibit electrical resistances of as much as 5.2 and 5.5 microohms.cm at room temperature. When circuits are formed at a high density, the wiring must have reduced width, so that the electrical resistance thereof per unit length increases. Accordingly, the signal transmission speed is reduced by voltage drop.

Thus, when using a conventional alumina ceramic material, the dielectric constant and the electric resistance of the conductors formed are so great that such circuit boards cannot be advantageously employed in electronic computers that must operate at high speeds.

Another problem which arises is the formation of cracks at the edges of through holes in the ceramic layers, there being electrically conductive material in the through holes making inter-layer connections between the conductive layers.

An object of the invention is to provide a multilayer ceramic circuit board in which at least one of the dielectric constant of the ceramic material and the resistance of the conductive material is reduced.

Another object of the present invention is to prevent the development of cracks in the boundaries between through holes and the ceramic material.

It is known from DE—A—3 324 933 published on 12 January 1984 to prepare a ceramic circuit board containing $SiO_2$, $B_2O_3$ and various additives such as $Al_2O_3$, Mgo, BaO, $AlPO_4$, $MgF_2$, $K_2O$, $Na_2O$ and $Bi_2O_3$. The coefficient of expansion can be controlled via a suitable choice of the $SiO_2$ component, thus leading to a reduction in crack formation.

The present invention provides a multilayered ceramic circuit board which comprises a plurality of ceramic layers each having a patterned electrically conductive layer thereon, each ceramic layer being integrally bonded to the adjacent ceramic layer or layers and electrically conductive material electrically connecting the conductive layers through through-holes formed in the ceramic layers to create a desired circuit, wherein the ceramic layers are made from 40 to 70% of a low-temperature softening glass composition and 60 to 30% of an $SiO_2$ containing additive, the low-temperature softening glass composition itself being constituted by 45 to 98% of a glass component and 55 to 2% of a refractory additive (all percentages being by weight).

Furthermore, according to the invention

(a) the glass component contains 15 to 80% $SiO_2$ and 20 to 60% $B_2O_3$ expressed as a percentage of the glass composition

(b) the glass composition has a softening point in the range 650° to 820°C

(c) the coefficient of thermal expansion of the material of the ceramic layer is less than $70 \times 10^{-7}/°C$ and less than that of the electrically conductive material, and its dielectric constant is less than 5.7;

(d) the electrically conductive material is made from a metal having a low resistivity selected from the group consisting of copper, silver, gold and their alloys and mixture thereof, and filler having a small coefficient of thermal expansion;

(e) the amount of the filler in the electrically conductive material is so selected that the difference between the coefficients of thermal expansion of the material of the ceramic layers and the electrically conductive material is less than $100 \times 10^{-7}/°C$; and

(f) the pitch of the through-holes in the ceramic layers is less than 0.5 mm.

Hereinafter all percentages given for compositions are by weight.

In the multilayered ceramic circuit board, the glass composition preferably consists essentially of $SiO_2$ in an amount of 10 to 80%, $B_2O_3$ in an amount of 15 to 65%, $Al_2O_3$ in an amount of 3 to 27%, up to 15% of MgO, up to 35% of BaO, up to 45% of $AlPO_4$, up to 18% of $MgF_2$, up to 10% of $K_2O$, up to 5% of $Na_2O$, and up to 17% of $Bi_2O_3$.

The $SiO_2$-containing additive preferably has a linear thermal expansion coefficient of less than $100 \times 10^{-7}/°C$ over the temperature range of 25 to 850°C.

More preferably, the glass composition consists essentially of $SiO_2$ in an amount of 30 to 50%, $B_2O_3$ in an amount of 20 to 50%, $Al_2O_3$ in an amount of 5 to 15%, up to 10% of MgO, up to 20% of BaO, up to 30% of $AlPO_4$, up to 10% of $MgF_2$, up to 10% of $K_2O$, up to 5% of $Na_2O$, and up to 10% of $Bi_2O_3$.

The $SiO_2$-containing additive may be a member selected from the group consisting of quartz $(100 \times 10^{-7}/°C)$, quartz glass $(0.5 \times 10^{-7}/°C)$, cristobalite $(100 \times 10^{-7}/°C)$, tridymite $(80 \times 10^{-7}/°C)$ and mixtures thereof. The figures in brackets are the respective thermal expansion coefficients.

2

The glass composition may alternatively consist essentially of 30 to 60% of $SiO_2$, 10 to 40% of $B_2O_3$, 5 to 15% of $Al_2O_3$, 2 to 15% of BaO and/or MgO, and up to 5% of $Na_2O$ and/or $K_2O$.

Known examples of materials with an excellent electric conductivity include silver (1.6 microohms.cm), copper (1.7 microohms.cm) and gold (2.2 microohms.cm). These materials melt at 961°C, 1083°C and 1063°C, respectively. To use these conductors on a ceramic multilayer circuit board, it is necessary to select a ceramic material that can be sintered at a temperature lower than these melting points. If fired at a temperature higher than the melting point of the electrically condutive material, the conductors formed by a printing method would melt, which would result in line breakages or short circuits.

Silver, copper and gold have small resistivities, but have coefficients of thermal expansion of as much as $193 \times 10^{-7}$/°C, $173 \times 10^{-7}$/°C, and $150 \times 10^{-7}$/°C, respectively.

To mount LIS chips directly thereon, the coefficient of thermal expansion of the ceramic material should not differ much from the coefficient of thermal expansion ($35 \times 10^{-7}$/°C) of silicon, so that reliability of the connection portions is not lost. It is therefore desired that the ceramic material has a coefficient of thermal expansion which is less than the coefficient of thermal expansion (about $70 \times 10^{-7}$/°C) of alumina which is currently used in practice. On the other hand, if the ceramic material has a coefficient of thermal expansion which is less than $70 \times 10^{-7}$/°C, the difference between it and the coefficient of thermal expansion of silver, copper or gold increases, and cracks may develop in the boundaries between through holes and the ceramic material.

The electrically conductive material should have a small resistivity and should preferably have a coefficient of thermal expansion such that cracks do not develop in the boundaries between through holes and the ceramic material.

To prepare a multilayer wiring board, conductors msut be formed in through holes so as to connect the wiring conductors through the ceramic materials that act as insulators. It is possible to reduce the pitch of the through-holes in order to prevent the occurrence of cracks in the boundaries between the through holes and the ceramic material, when using silver, copper or gold, which have small resistivities but large coefficients of thermal expansion, as the electrically conductive material.

When tungsten or molybdenum (with a coefficient of thermal expansion of $4.5 \times 10^{-7}$/°C or $5.4 \times 10^{-7}$/°C) is used as the electrically conductive material with the alumina ceramic material that is used in practice at present and which has a coefficient of thermal expansion of $70 \times 10^{-7}$/°C, a reduction in the pitch of the through holes results in cracks between the through holes. Therefore, it is not possible to reduce the pitch of the through holes. Cracks do not develop when the through holes have a diameter of 0.2 mm and a pitch of more than 0.8 mm. This means that there is a limitation imposed on the density of wiring when an electrically conductive material such as tungsten or molybdenum which has a small coefficient of thermal expansion is used with an alumina ceramic material.

However, when the electrically conductive material contains silver, copper or gold, and when the ceramic material has a coefficient of thermal expansion of less than $70 \times 10^{-7}$/°C, arcuate cracks develop in the boundaries between through holes and the ceramic material when the through holes have a diameter of 0.1 mm and a pitch of more than 0.5 mm, in contrast with the use of an alumina ceramic material and tungsten, or an alumina ceramic material and molybdenum. It has, however, been discovered that no cracks develop when the pitch of the through holes is reduced to less than 0.5 mm.

In the present invention there is used in the through holes an electrically conductive material composed of copper, gold, and silver and their alloys, and mixtures thereof, and which also contains a material with a small coefficient of thermal expansion as a filler, in order to reduce the coefficient of thermal expansion of the resultant electrically conductive material. Electrically conductive material of this type is known. Thus US—A—3 450 545 discloses a metallisation composition for electronic use, which comprises a noble metal or noble metal alloy, plus a metal borosilicate glass as a binder, and an oxide precursor, the object being to improve the joint strength and inhibit fissuring of the metallizings when coatings of the composition are fired on a ceramic substrate.

If the ceramic material has a coefficient of thermal expansion of less than $70 \times 10^{-7}$/°C, the difference between the coefficient of thermal expansion of the ceramic material and the coefficient of thermal expansion of the electrically conductive material could exceed $100 \times 10^{-7}$/°C. In this case, cracks may develop to some extent in the boundaries between through holes and the ceramic material. It has, however, been found that no cracks develop when the difference between the coefficients of thermal expansion of the ceramic material and the electrically conductive material is less than $100 \times 10^{-7}$/°C.

Thermal stresses caused by differences in coefficients of thermal expansion were analyzed by a finite element method, using a system in which through holes were provided in a ceramic material at equal distances. It was found that when the coefficient of thermal expansion of the ceramic material is less than the coefficient of thermal expansion of the electrically conductive material, tensile stresses are exerted in the radial direction from the centers of the through-holes, and compressive stresses are exerted in the circumferential direction thereof. It is known that ceramic materials are generally strong against compressive stresses but are weak against tensile stresses. In this case, the stresses act to separate the boundaries between the through holes and the ceramic material.

It has also been confirmed that if the pitch of the through holes is reduced, the thermal stresses (tensile stresses) separating the through holes from the ceramic material are reduced. Conversely, when the coefficient of thermal expansion of the ceramic material is larger than the coefficient of thermal expansion of the electrically conductive material, i.e., when tungsten or molybdenum is used as the electrically conductive material with an alumina ceramic material, compressive stresses are exerted in the radial direction and tensile stresses are exerted in the circumferential direction, viewed from the centers of the through holes. That is, cracks propagate between the through holes, and the thermal stresses develop in a direction that reduces the stresses. It was confirmed that if the pitch of the through holes is reduced, the tensile stresses increase in the circumferential direction, and cracks develop easily between the through holes. The results of the stress analysis also indicate that the pitch of the through holes should be reduced when the coefficient of thermal expansion of the ceramic material is less than that of the electrically conductive material. That is, by forming the wiring at a high density, the generation of thermal stresses can be reduced and the development of cracks restrained.

It was also confirmed that if the coefficient of thermal expansion of the electrically conductive material is reduced, the thermal stresses (tensile stresses) separating the through holes from the ceramic material are reduced.

Examples of the invention will now be given with reference to the accompanying drawing, in which:

Fig. 1 is a vertical section through a multi-layered ceramic circuit board; and

Fig. 2 is a sectional view taken along the line II—II of Fig. 1.

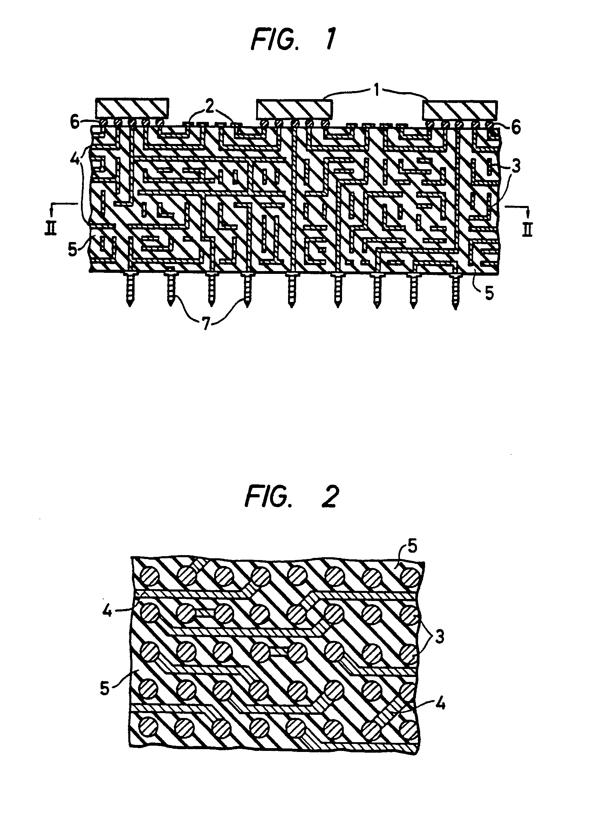

Figs. 1 and 2 show one form of multilayered ceramic circuit board to which the invention can be applied. Semiconductor devices 1 (e.g. chips) are mounted via connections 6 on a circuit board formed by a ceramic matrix 5 made from a plurality of ceramic layers sintered together. Between the ceramic layers 5 are wiring layers 4 of electrically conductive material and connections between the layers 4 are made by electrically conductive material 3 in through-holes in the ceramic layers. At the top face of the board, there are terminals 2 and at the bottom face there are pin terminals 7.

Examples of the Invention

Working examples of the present invention will be described below. In these exmaples, all parts and percentages are by weight.

The compositions and properties of low-temperature softening glasses which are used as starting materials are shown in Table 1.

Mixing ratios of the low-temperature softening glasses and silicon oxide which are the basic materials for preparing the ceramic materials, and the sintering temperatures, and the results obtained in the form of presence or absence of cracks in the vicinity of through holes, are shown in Tables 2 to 7.

In all the examples, the conductive material used in the through-holes was the same as that used for the conductive layers between the ceramic layers.

In Table 1, the materials other than $SiO_2$ and $B_2O_3$ constitute the refractory additive.

4

Table 1

| No. | Composition (% by weight) | | | | | | | | | | Properties | |
|---|---|---|---|---|---|---|---|---|---|---|---|---|
| | $SiO_2$ | $Al_2O_3$ | MgO | BaO | $B_2O_3$ | $AlPO_4$ | $MgF_2$ | $K_2O$ | $Na_2O$ | $Bi_2O_3$ | Softening point (°C) | Specific inductive capacity (at 1MHz) |
| 1 | 40-50 | 20-25 | 10-15 | – | 5-15 | – | – | – | – | 5-15 | 900-1000 | 5.0-6.0 |
| 2 | 20-30 | 15-20 | 5-10 | – | 30-50 | – | – | – | – | 5-15 | 700-800 | 4.5-5.5 |
| 3 | 20-30 | 15-20 | 5-10 | – | 40-60 | – | – | – | – | – | 700-800 | 4.0-5.0 |
| 4 | 15-30 | 10-20 | – | 20-25 | 30-50 | – | – | – | – | – | 650-740 | 4.8-5.5 |
| 5 | 20-30 | 15-23 | – | 25-30 | 20-30 | – | – | – | – | – | 750-700 | 5.0-5.7 |
| 6 | 35-50 | 5-15 | – | 7.5-15 | 25-40 | – | – | 0-0.1 | 0-0.1 | – | 700-800 | 4.1-4.5 |
| 7 | 40-60 | 5-15 | – | 5-15 | 20-30 | – | – | 1-4.5 | 1-4.5 | – | 650-750 | 4.5-5.3 |
| 8 | 20-40 | – | – | – | 20-40 | 20-40 | 5-15 | – | – | – | 650-750 | 4.0-5.0 |
| 9 | 60-80 | 0-2 | – | – | 20-30 | – | – | 1-3 | 1-3 | – | 700-800 | 4.0-5.0 |
| 10 | 30-50 | – | – | – | 20-40 | 20-40 | – | – | – | – | 730-820 | 4.0-5.0 |
| 11 | 30-50 | 15-20 | 5-10 | – | 30-50 | – | – | – | – | – | 700-800 | 4.0-5.0 |
| 12 | 35-45 | 5-15 | 2.5-7.5 | – | 30-50 | – | – | 1.5-5 | – | – | 650-750 | 4.6-5.0 |
| 13 | 30-50 | 5-10 | 5-10 | 5-10 | 30-50 | – | – | 2-7 | – | – | 650-750 | 4.3-5.0 |

EP 0 133 010 B1

EP 0 133 010 B1

## Table 2

| No. | Low-temperature softening glass | | Silicon Oxide | | | | Sintering temperature (°C) | Pitch of through holes (mm) | Presence of cracks |
|---|---|---|---|---|---|---|---|---|---|
| | Glass No. | Quantity | Name | Quantity | Name | Quantity | | | |
| 14 | 2 | 60 | Quartz | 40 | – | – | 800 | 0.25 | no |
| 15 | " | " | Cristobalite | " | – | – | " | 0.25 | " |
| 16 | " | " | Tridymite | " | – | – | " | 0.3 | " |
| 17 | " | " | Quartz glass | 35 | Quartz | 5 | " | 0.6 | yes |
| 18 | " | " | " | 30 | " | 10 | " | 0.6 | " |
| 19 | " | " | " | 20 | Cristobalite | 20 | " | 0.5 | no |
| 20 | " | " | " | 10 | " | 30 | " | 0.5 | " |
| 21 | " | " | " | 5 | " | 35 | " | 0.5 | " |
| 22 | " | 40 | Quartz | 30 | " | 30 | " | 0.25 | " |
| 23 | " | " | " | 10 | " | 50 | " | 0.25 | " |
| 24 | " | 60 | Cristobalite | 20 | Tridymite | 20 | " | 0.3 | " |
| 25 | " | " | Quartz glass | 10 | " | 30 | " | 0.4 | " |
| 26 | " | " | " | 20 | " | 20 | " | 0.5 | " |
| 27 | 4 | " | Quartz | 40 | – | – | 800 | 0.25 | " |
| 28 | " | " | Cristobalite | 40 | – | – | " | 0.25 | " |
| 29 | " | " | Tridymite | " | – | – | " | 0.25 | " |

Table 2 (continued)

No.                    Mixture ratio (% by weight)

| No. | Low-temperature softening glass | | Silicon Oxide | | | | Sintering temperature (°C) | Pitch of through holes (mm) | Presence of cracks |
|---|---|---|---|---|---|---|---|---|---|
| | Glass No. | Quantity | Name | Quantity | Name | Quantity | | | |
| 30 | 4 | 60 | Quartz glass | 35 | Quartz | 5 | 800 | 2.0 | yes |
| 31 | " | " | " | 30 | " | 10 | " | 1.0 | " |
| 32 | " | " | " | 20 | " | 20 | " | 0.5 | no |
| 33 | " | " | " | 10 | " | 30 | " | 0.4 | " |
| 34 | " | " | " | 5 | " | 35 | " | 0.3 | " |
| 35 | " | 40 | " | 30 | " | 30 | 900 | 0.4 | " |
| 36 | " | " | " | 10 | " | 50 | " | 0.2 | " |
| 37 | 5 | 60 | Quartz | 40 | – | – | 850 | 0.25 | " |
| 38 | " | " | Cristobalite | " | – | – | " | 0.25 | " |
| 39 | " | " | Tridymite | " | – | – | " | 0.3 | " |
| 40 | " | " | Quartz glass | 10 | Cristobalite | 30 | " | 0.4 | " |
| 41 | " | " | " | 20 | " | 20 | " | 0.5 | " |
| 42 | " | " | " | 20 | Tridymite | 20 | " | 0.5 | " |
| 43 | " | " | Quartz | 20 | Cristobalite | 20 | " | 0.25 | " |
| 44 | " | " | " | 20 | Tridymite | 20 | " | 0.25 | " |
| 45 | " | " | Cristobalite | 20 | " | 20 | " | 0.3 | " |

## Table 2 (continued)

| No. | Low-tempera-ture soften-ing glass | | Silicon Oxide | | | | Sintering tempera-ture (°C) | Pitch of through holes (mm) | Presence of cracks |
|---|---|---|---|---|---|---|---|---|---|
| | Glass No. | Quantity | Name | Quan-tity | Name | Quan-tity | | | |
| 46 | 7 | 60 | Quartz | 40 | – | – | 800 | 0.25 | no |
| 47 | " | " | Cristobalite | " | – | – | " | 0.25 | " |
| 48 | " | " | Tridymite | " | – | – | " | 0.3 | " |
| 49 | " | " | Quartz glass | 35 | Quartz | 5 | " | 1.5 | yes |
| 50 | " | " | " | 30 | " | 10 | " | 1.5 | " |
| 51 | " | " | " | 20 | " | 20 | " | 1.5 | " |
| 52 | " | " | " | 10 | " | 30 | " | 1.0 | " |
| 53 | " | " | " | 5 | " | 35 | " | 1.0 | " |
| 54 | " | 50 | " | 30 | " | 20 | 850 | 0.5 | no |
| 55 | " | " | " | 20 | " | 30 | " | 0.4 | " |
| 56 | " | " | " | 10 | " | 40 | 800 | 0.25 | " |
| 57 | " | 70 | " | 15 | " | 15 | " | 0.5 | " |
| 58 | " | 80 | " | 10 | " | 10 | " | 0.6 | yes |
| 59 | " | 90 | " | 5 | " | 5 | " | 0.8 | " |
| 60 | " | 50 | " | " | " | 45 | " | 0.2 | no |
| 61 | " | 40 | " | " | " | 55 | 850 | 0.2 | " |
| 62 | " | 30 | " | " | Cristobalite | 65 | 900 | 0.25 | " |

Table 2 (continued)

No.                    Mixture ratio (% by weight)

| No. | Low-temperature softening glass | | Silicon Oxide | | | | Sintering temperature (°C) | Pitch of through holes (mm) | Presence of cracks |
|---|---|---|---|---|---|---|---|---|---|
| | Glass No. | Quantity | Name | Quantity | Name | Quantity | | | |
| 63 | 12 | 40 | Quartz glass | 50 | Quartz | 10 | 850 | 2.0 | yes |
| 64 | " | " | " | 40 | " | 20 | " | 0.8 | " |
| 65 | " | " | " | 30 | " | 30 | " | 0.4 | no |
| 66 | " | " | " | 20 | " | 40 | " | 0.25 | " |
| 67 | " | " | " | 10 | " | 50 | " | 0.2 | " |
| 68 | " | 60 | " | 20 | " | 20 | 800 | 0.4 | " |
| 69 | " | 80 | " | 5 | " | 15 | " | 0.4 | " |
| 70 | " | 90 | " | 5 | " | 5 | " | 0.4 | " |
| 71 | " | 60 | " | 20 | Cristobalite | 20 | " | 0.5 | " |
| 72 | " | " | " | 10 | " | 30 | " | 0.4 | " |
| 73 | " | " | Quartz | 40 | — | — | " | 0.25 | " |
| 74 | " | " | Cristobalite | " | — | — | " | 0.25 | " |
| 75 | " | " | Tridymite | " | — | — | " | 0.25 | " |
| 76 | " | 50 | Quartz | 45 | Cristobalite | 5 | 850 | 0.2 | " |
| 77 | " | " | Cristobalite | 25 | Tridymite | 25 | " | 0.3 | " |

EP 0 133 010 B1

## Table 3

| No. | Mixture ratio (% by weight) | | | | | | | |
|---|---|---|---|---|---|---|---|---|
| | Low-temperature softening glass | | Silicon Oxide | | | | Sintering temperature (°C) | Coefficient of thermal expansion (10$^{-7}$/°C) |
| | Glass No. | Quantity | Name | Quantity | Name | Quantity | | |
| 78 | 2 | 60 | Quartz glass | 10 | Tridymite | 30 | 800 | 60 |
| 79 | " | " | " | 20 | " | 20 | " | 52 |
| 80 | " | " | " | 20 | Cristobalite | 20 | " | 50 |
| 81 | " | " | " | 10 | " | 30 | " | 61 |
| 82 | " | " | Quartz | 40 | – | – | " | 66 |
| 83 | " | " | Cristobalite | " | – | – | " | 67 |
| 84 | " | " | Tridymite | " | – | – | " | 65 |
| 85 | 4 | 60 | Quartz glass | 35 | Quartz | 5 | 800 | 32 |
| 86 | " | " | " | 30 | " | 10 | " | 40 |
| 87 | " | " | " | 20 | " | 20 | " | 55 |
| 88 | " | " | " | 10 | " | 30 | " | 70 |
| 89 | " | 40 | " | 30 | " | 30 | 900 | 63 |
| 90 | " | 70 | Quartz | 30 | – | – | 850 | 65 |
| 91 | " | " | Cristobalite | " | – | – | " | 66 |
| 92 | " | " | Tridymite | " | – | – | " | 64 |
| 93 | 5 | 60 | Quartz glass | 10 | Cristobalite | 30 | " | 60 |

Table 3 (continued)

| No. | Mixture ratio (% by weight) | | | | | | Sintering tempera-ture (°C) | Coefficient of thermal expan-sion $(10^{-7}/°C)$ |
|---|---|---|---|---|---|---|---|---|
| | Low-tempera-ture soften-ing glass | | Silicon Oxide | | | | | |
| | Glass No. | Quantity | Name | Quan-tity | Name | Quan-tity | | |
| 94 | 5 | 60 | Quartz glass | 20 | Cristobalite | 20 | 850 | 52 |
| 95 | " | " | " | 20 | Tridymite | 20 | " | 51 |
| 96 | " | " | Quartz | 40 | – | – | " | 66 |
| 97 | " | " | Cristobalite | " | – | – | " | 67 |
| 98 | " | " | Tridymite | " | – | – | " | 65 |
| 99 | 7 | 70 | Quartz | 30 | – | – | 850 | 69 |
| 100 | " | " | Cristobalite | " | – | – | " | 70 |
| 101 | " | " | Tridymite | " | – | – | " | 68 |
| 102 | 12 | 60 | Quartz glass | 20 | Cristobalite | 20 | 800 | 53 |
| 103 | " | " | " | 10 | " | 30 | " | 63 |
| 104 | " | " | " | 20 | Quartz | 20 | " | 60 |
| 105 | " | " | Quartz | 40 | – | – | " | 64 |
| 106 | " | " | Cristobalite | " | – | – | " | 65 |
| 107 | " | " | Tridymite | " | – | – | " | 63 |
| 108 | " | 40 | Quartz glass | 40 | Quartz | 20 | 850 | 45 |

EP 0 133 010 B1

## Table 4

| No. | Ceramic material No. | Electrically conductive material | | | | Sintering temperature (°C) | Presence of cracks |
|---|---|---|---|---|---|---|---|
| | | Blending ratio (% by weight) | | | Coefficient of thermal expansion $(10^{-7}/°C)$ | | |
| | | Quantity of silver | Name | Quantity | | | |
| 109 | 78 | 80 | Quartz glass | 20 | 165 | 800 | yes |
| 110 | " | 75 | " | 25 | 157 | " | no |
| 111 | " | 70 | " | 30 | 150 | " | " |
| 112 | " | 80 | Spodumene | 20 | 154 | " | " |
| 113 | " | 70 | Alumina | 30 | 156 | " | " |
| 114 | 82 | 80 | Quartz glass | 20 | 165 | " | " |
| 115 | " | 85 | Spodumene | 15 | 164 | " | " |
| 116 | " | 90 | β-Eucryptite | 10 | 170 | " | yes |
| 117 | " | 80 | " | 20 | 150 | " | no |
| 118 | 86 | 60 | Quartz glass | 40 | 136 | " | " |
| 119 | " | 70 | " | 30 | 150 | " | yes |
| 120 | " | 70. | Spodumene | 30 | 135 | " | no |
| 121 | 92 | 80 | Quartz glass | 20 | 165 | 850 | yes |
| 122 | " | 75 | " | 25 | 157 | " | no |
| 123 | " | 80 | β-Eucryptite | 20 | 150 | " | " |
| 124 | " | 80 | Petalite | 20 | 152 | " | " |
| 125 | 96 | 80 | Quartz glass | 20 | 165 | " | " |

Table 4 (continued)

| No. | Ceramic material No. | Electrically conductive material | | | | Sintering temperature (°C) | Presence of cracks |
|---|---|---|---|---|---|---|---|
| | | Blending ratio (% by weight) | | | Coefficient | | |
| | | Quantity of silver | Name | Quantity | of thermal expansion $(10^{-7}/°C)$ | | |
| 126 | 96 | 85 | Petalite | 15 | 162 | 85C | no |
| 127 | " | 90 | β-Eucryptite | 10 | 170 | " | yes |
| 128 | 100 | 80 | Quartz glass | 20 | 165 | " | no |
| 129 | " | 90 | " | 10 | 179 | " | yes |
| 130 | 105 | 85 | Spodumene | 15 | 164 | 800 | no |
| 131 | " | 80 | Quartz glass | 20 | 165 | " | yes |
| 132 | " | 75 | " | 25 | 157 | " | no |
| 133 | " | 70 | Alumina | 30 | 156 | " | " |
| 134 | 108 | 70 | Spodumene | 30 | 135 | 850 | " |
| 135 | " | 60 | Quartz glass | 40 | 136 | " | " |
| 136 | " | 70 | " | 30 | 150 | " | yes |
| 137 | " | 60 | Alumina | 40 | 142 | " | no |

Table 5

| No. | Ceramic material No. | Electrically conductive material | | | | Sintering temperature (°C) | Presence of cracks |
|---|---|---|---|---|---|---|---|
| | | Blending ratio (% by weight) | | | Coefficient of thermal expansion $(10^{-7}/°C)$ | | |
| | | Quantity of copper | Name | Quantity | | | |
| 138 | 78 | 90 | Quartz glass | 10 | 162 | 800 | yes |
| 139 | " | 80 | " | 20 | 149 | " | no |
| 140 | " | 75 | " | 25 | 142 | " | " |
| 141 | " | 85 | Spodumene | 15 | 147 | " | " |
| 142 | " | 80 | Alumina | 20 | 151 | " | " |
| 143 | 82 | 90 | Quartz glass | 10 | 162 | 800 | " |
| 144 | " | 90 | Spodumene | 10 | 156 | " | " |
| 145 | " | 95 | β-Eucryptite | 5 | 161 | " | " |
| 146 | " | 85 | Alumina | 15 | 157 | " | " |
| 147 | 86 | 80 | Quartz glass | 20 | 149 | 800 | yes |
| 148 | " | 70 | " | 30 | 136 | " | no |
| 149 | " | 80 | Spodumene | 20 | 138 | " | " |
| 150 | 92 | 90 | " | 10 | 156 | 850 | " |
| 151 | " | 90 | Quartz glass | 10 | 162 | " | " |
| 152 | " | 95 | " | 5 | 167 | " | yes |
| 153 | " | 85 | Alumina | 15 | 157 | " | no |
| 154 | " | 95 | Petalite | 5 | 163 | " | " |
| 155 | 96 | 90 | Quartz glass | 10 | 162 | 850 | " |

EP 0 133 010 B1

Table 5 (continued)

| No. | Ceramic material No. | Electrically conductive material | | | | Sintering temperature (°C) | Presence of cracks |
|-----|-----|-----|-----|-----|-----|-----|-----|
| | | Blending ratio (% by weight) | | | Coefficient of thermal expansion $(10^{-7}/°C)$ | | |
| | | Quantity of copper | Name | Quantity | | | |
| 156 | 96 | 95 | Spodumene | 5 | 164 | 850 | no |
| 157 | " | 95 | β-Eucryptite | 5 | 161 | " | " |
| 158 | 100 | " | " | " | " | " | " |
| 159 | " | 90 | Alumina | 10 | 162 | " | " |
| 160 | 105 | 95 | Spodumene | 5 | 164 | 800 | " |
| 161 | " | 90 | Quartz glass | 10 | 162 | " | " |
| 162 | " | 95 | Alumina | 5 | 168 | " | yes |
| 163 | " | 90 | " | 10 | 162 | " | no |
| 164 | 108 | 85 | Spodumene | 15 | 147 | 850 | yes |
| 165 | " | 75 | Quartz glass | 25 | 142 | " | no |
| 166 | " | 70 | Alumina | 30 | 141 | " | " |
| 167 | " | 80 | β-Eucryptite | 20 | 136 | " | " |

EP 0 133 010 B1

Table 6

| No. | Ceramic material No. | Electrically conductive material | | | | Sintering temperature (°C) | Presence of cracks |
|---|---|---|---|---|---|---|---|
| | | Blending ratio (% by weight) | | | Coefficient of thermal expansion $(10^{-7}/°C)$ | | |
| | | Quantity of silver | Low-temperature softening glass No. | Quantity | | | |
| 168 | 78 | 80 | 2 | 20 | 164 | 800 | yes |
| 169 | " | 70 | " | 30 | 150 | " | no |
| 170 | 80 | 70 | " | 30 | 150 | " | " |
| 171 | 82 | 85 | " | 15 | 171 | " | yes |
| 172 | " | 80 | " | 20 | 164 | " | no |
| 173 | 84 | " | " | " | " | " | " |
| 174 | 86 | 70 | 4 | 30 | 150 | " | yes |
| 175 | " | 60 | " | 40 | 136 | " | no |
| 176 | 88 | 80 | " | 20 | 164 | " | " |
| 177 | " | 75 | " | 25 | 157 | " | " |
| 178 | 90 | 80 | " | 20 | 164 | 850 | " |
| 179 | " | 75 | " | 25 | 157 | " | " |
| 180 | 92 | 80 | " | 20 | 164 | " | " |
| 181 | 94 | 80 | 5 | 20 | 163 | " | yes |
| 182 | " | 75 | " | 25 | 156 | " | no |
| 183 | 96 | 80 | " | 20 | 163 | " | " |
| 184 | 97 | 80 | " | 20 | 163 | " | " |

Table 6 (continued)

| No. | Ceramic material No. | Electrically conductive material | | | | Sintering temperature (°C) | Presence of cracks |
|---|---|---|---|---|---|---|---|
| | | Blending ratio (% by weight) | | | Coefficient of thermal expansion $(10^{-7}/°C)$ | | |
| | | Quantity of silver | Low-tempera-ture soften-ing glass No. | Quan-tity | | | |
| 185 | 98 | 80 | 5 | 20 | 163 | 850 | no |
| 186 | 100 | 80 | 7 | 20 | 166 | " | " |
| 187 | " | 85 | " | 15 | 172 | " | yes |
| 188 | 101 | 80 | " | 20 | 166 | " | no |
| 189 | 102 | 75 | 12 | 25 | 155 | " | yes |
| 190 | " | 70 | " | 30 | 147 | " | no |
| 191 | 104 | 75 | " | 25 | 155 | 800 | " |
| 192 | " | 80 | " | 20 | 162 | " | yes |
| 193 | 105 | 80 | " | 20 | 162 | " | no |
| 194 | 106 | 80 | " | 20 | 162 | " | no |
| 195 | " | 75 | " | 25 | 155 | " | " |
| 196 | 107 | 80 | " | 20 | 162 | " | " |
| 197 | 108 | 70 | " | 30 | 147 | " | yes |
| 198 | " | 65 | " | 35 | 139 | " | no |

## Table 7

| No. | Ceramic material No. | Electrically conductive material | | | | Sintering temperature (°C) | Presence of cracks |
|---|---|---|---|---|---|---|---|
| | | Blending ratio (% by weight) | | | Coefficient of thermal expansion $(10^{-7}/°C)$ | | |
| | | Quantity of copper | Low-temperature softening glass No. | Quantity | | | |
| 199 | 78 | 90 | 2 | 10 | 161 | 800 | yes |
| 200 | " | 85 | " | 15 | 154 | " | no |
| 201 | 80 | 80 | " | 20 | 148 | " | " |
| 202 | 82 | 90 | " | 10 | 161 | " | " |
| 203 | " | 85 | " | 15 | 154 | " | " |
| 204 | 84 | 90 | " | 10 | 161 | " | " |
| 205 | 86 | 80 | 4 | 20 | 148 | " | yes |
| 206 | " | 70 | " | 30 | 138 | " | no |
| 207 | 88 | 90 | " | 10 | 161 | " | " |
| 208 | " | 85 | " | 15 | 155 | " | " |
| 209 | 90 | 90 | " | 10 | 161 | 850 | " |
| 210 | " | 80 | " | 20 | 148 | " | " |
| 211 | 92 | 90 | " | 10 | 161 | " | " |
| 212 | 94 | 90 | 5 | 10 | 160 | " | yes |
| 213 | " | 80 | " | 20 | 147 | " | no |
| 214 | 96 | 90 | " | 10 | 160 | " | " |
| 215 | 97 | 95 | " | 5 | 167 | " | " |

## Table 7 (continued)

| No. | Ceramic material No. | Electrically conductive material | | | | Sintering temperature (°C) | Presence of cracks |
|---|---|---|---|---|---|---|---|
| | | Blending ratio (% by weight) | | | Coefficient of thermal expansion $(10^{-7}/°C)$ | | |
| | | Quantity of copper | Low-temperature softening glass No. | Quantity | | | |
| 216 | 98 | 90 | 5 | 10 | 160 | 850 | no |
| 217 | 100 | 90 | 7 | 10 | 161 | " | " |
| 218 | " | 85 | " | 15 | 155 | " | " |
| 219 | 101 | 95 | " | 5 | 167 | " | " |
| 220 | 102 | 85 | 12 | 15 | 153 | 800 | " |
| 221 | " | 80 | " | 20 | 146 | " | " |
| 222 | 104 | 90 | " | 10 | 160 | " | " |
| 223 | " | 80 | " | 20 | 146 | " | " |
| 224 | 105 | 90 | " | 10 | 160 | " | " |
| 225 | 106 | 90 | " | 10 | 160 | " | " |
| 226 | " | 95 | " | 5 | 166 | " | yes |
| 227 | 107 | 90 | " | 10 | 160 | " | no |
| 228 | 108 | 80 | " | 20 | 146 | " | yes |
| 229 | " | 75 | " | 25 | 140 | " | no |

Silicon oxide exists in a variety of forms such as quartz, quartz glass, cristobalite, tridymite, etc., which have different coefficients of thermal expansion. A desired coefficient of thermal expansion can be obtained by using these various silicon oxides as fillers.

## Example 1

100 parts of each of starting ceramic materials were mixed at the mixture ratios shown in Table 2 in a ball mill for 24 hours. 6.0 parts of a polyvinyl butyral resin, 2.4 parts dioctyl phthalate, 23.0 parts trichloroethylene, 9.0 parts perchloroethylene and 6.0 parts butyl alcohol were introduced into the ball mill and mixed therein for 10 hours. The mixtures assumed a slurry form. The slurries were continuously applied at a thickness of 0.25 mm onto polyester film using a doctor blade. The sheets were heated at a maximum temperature of 120°C so that solvents therein were evaporated. Green sheets were thus obtained, which were cut into pieces of a predetermined shape. Through holes 0.1 mm in diameter were formed by a punching method at a pitch of between 0.2 and 2.0 mm, and the through holes were filled with an electrically conductive paste of silver by a printing method to form conductors for connecting wiring between the layers. Wiring conductors of a predetermined pattern were printed onto the surface of the sheets. Six green sheets on which silver conductors had been printed were stacked with the aid of guide holes, and were stuck together at 120°C under a pressure of 10 kg/cm².

The stacked green sheets were introduced into a furnace and were fired in an atmosphere of air. The firing was effected at the sintering temperatures shown in Table 2 for about 30 minutes.

Ceramic circuit boards with six electrically conductive layers was obtained through these steps. Since silver was used as the conductor for the circuit boards, the resistivity of the wiring was 0.4 ohm/cm at a wiring width of 80 μm.

When the pitch of the through holes was more than 0.5 mm, cracks developed to some extent in the vicinities of the through holes. This resulted from the difference between the coefficients of thermal expansion of silver used as the conductors, and the ceramic material. When the pitch of the through holes was less than 0.5 mm, no cracks developed at all. It was found that even when there was a large difference between the coefficients of thermal expansion, the development of cracks could be eliminated by reducing the pitch of through holes, i.e., by forming the wiring at a high density. This result could only be obtained when the coefficient of thermal expansion of the ceramic material was less than the coefficient of thermal expansion of the electrically conductive material.

## Example 2

100 parts of each of starting ceramic materials were mixed at the mixture ratios shown in Table 2 in a ball mill for 24 hours, in the same manner as in Example 1. 5.9 parts methacrylic acid resin, 2.4 parts dioctyl phthalate, 23.0 parts ethyl acetate, 9.0 parts butyl acetate and 6.0 parts butyl alcohol were introduced into the ball mill and mixed therein for 10 hours. The mixtures assumed a slurry form. The slurries were continuously applied at a thickness of 0.25 mm onto polyester film using a doctor blade. The sheets were heated at a maximum temperature of 120°C so that solvents therein were evaporated. Green sheets were thus obtained, which were cut into pieces of a predetermined shape. Through holes 0.1 mm in diameter were formed by a punching method at a pitch of between 0.2 and 2.0 mm, and six green sheets on which an electrically conductive paste of copper had been formed were stacked with the aid of guide holes, and were stuck together at 120°C under a pressure of 15 kg/cm².

The stacked green sheets were introduced into a furnace and were fired in a nitrogen atmosphere containing between 3 to 7 % hydrogen. Small amounts of water vapour were introduced into the atmosphere to promote the thermal decomposition of the organic binders. Firing was effected at the same temperature as in Example 1.

Circuit boards with six electrically conductive layers were obtained through these steps. Since copper was used as the conductor for the circuit boards, the resistivity of the wiring was 0.4 ohm/cm at a wiring width of 80 μm.

When the pitch of the through holes was more than 0.6 mm cracks developed to some extent in the vicinities of the through holes, as in Example 1. This was caused by the difference between the coefficients of thermal expansion of the copper used as the conductors, and the ceramic material. When the pitch of the through holes was less than 0.6 mm, no cracks developed at all, even when there was a large difference between the coefficients of thermal expansion. It was found that the development of cracks could be eliminated by reducing the pitch of the through holes, i.e., by forming the wiring at a high density.

## Example 3

100 parts of each of starting ceramic materials were mixed at the mixture ratios shown in Table 3 in a ball mill for 24 hours. 6.0 parts of a polyvinyl butyral resin, 2.4 parts dioctyl phthalate, 23.0 parts trichloroethylene, 9.0 parts perchloroethylene and 6.0 parts butyl alcohol were introduced into the ball mill and mixed therein for 10 hours. The mixtures assumed a slurry form. The slurries were continuously applied at a thickness of 0.25 mm onto polyester film using a doctor blade. The sheets were heated at a maximum temperature of 120°C to evaporate the solvents therein. Green sheets were thus obtained, which were cut into pieces of a predetermined shape. Predetermined through holes were formed therein by a punching method. Electrically conductive pastes were prepared at the mixture ratios shown in Table 4, and conductors were formed in the through holes by a printing method, to connect the wiring layers. Wiring conductors of a predetermined pattern were also printed on the surfaces of the sheets. Six green sheets on which conductors of silver- or gold-types had been printed were stacked with the aid of guide holes, and were stuck together at 120°C under a pressure of 10 kg/cm$^2$.

The stacked green sheets were introduced into a furnace and were fired in an atmosphere of air. The firing was effected at the sintering temperature shown in Table 3 for about 30 minutes.

Ceramic circuit boards with six electrically conductive layers were obtained through these steps.

Cracks developed to some extent in the boundaries between the through holes and the ceramic material when the difference between the coefficients of thermal expansion of the ceramic material and the electrically conductive material was more than $100 \times 10^{-7}$/°C. However, no cracks developed at all when the coefficient of thermal expansion of the electrically conductive material was so low that the difference between it and the coefficient of expansion of the ceramic material was less than $100 \times 10^{-7}$/°C.

## Example 4

100 parts of each starting ceramic materials were mixed at the mixture ratios shown in Table 3 in a ball mill for 24 hours, in the same manner as in Example 1. 5.9 parts methacrylic acid resin, 2.4 parts dioctyl phthalate, 23.0 parts ethyl acetate, 9.0 parts butyl acetate and 6.0 parts butyl alcohol were introduced into the ball mill and mixed therein for 10 hours. The mixtures assumed a slurry form. The slurries were continuously applied at a thickness of 0.25 mm onto polyester film using a doctor blade. The sheets were heated at a maximum temperature of 120°C to evaporate the solvents therein. Green sheets were thus formed, which were then cut into pieces of a predetermined shape, and predetermined through holes were formed therein by a punching method. Electrically conductive pastes were prepared at the mixture ratios shown in Table 5, and conductors were formed in the through holes by a printing method to connect the wiring layers. Wiring conductors of a predetermined pattern were also printed onto the surfaces of the sheets. Six green sheets on which conductors of the copper-type had been printed were stacked with the aid of guide holes, and were stuck together at 120°C under a pressure of 10 kg/cm$^2$.

The stacked green sheets were introduced into a furnace and were fired in a nitrogen atmosphere containing between 3 to 7 % hydrogen. Small quantities of water vapor were introduced into the atmosphere to promote the thermal decomposition of the organic binders. The firing was effected at the same temperature as in Example 1.

Circuit boards with six electrically conductive layers were obtained through these steps.

Cracks developed to some extent in the boundaries between the through holes and the ceramic material when the difference between the coefficients of thermal expansion of the ceramic material and the electrically conductive material was more than $100 \times 10^{-7}$/°C. However, no cracks developed at all when the coefficient of thermal expansion of the electrically conductive material was so low that the difference between it and the coefficient of thermal expansion of the ceramic material was less than $100 \times 10^{-7}$/°C.

## Example 5

Ceramic circuit boards were obtained according to the same procedure as that of Example 3, with the exception of using, as the electrically conductive material, a silver-type paste containing the same low-temperature softening glass as that used for the ceramic starting material.

Table 6 shows the blending ratios of the electrically conductive materials, the coefficients of thermal expansion, and the presence of cracks in the vicinities of the through holes when these electrically conductive materials were used.

Cracks developed to some extent in the boundaries between the through holes and the ceramic material when the difference between the coefficients of thermal expansion of the ceramic material and the electrically conductive material was more than $100 \times 10^{-7}$/°C. However, no cracks developed at all when the coefficient of thermal expansion of the electrically conductive material was so low that the difference between it and the coefficient of thermal expansion of the ceramic material was less than $100 \times 10^{-7}$/°C.

## Example 6

Ceramic circuit boards were obtained according to the same precedure as that of Example 4, with the exception of using, as the electrically conductive material, a copper-type paste containing the same low-temperature softening glass as was used for the ceramic starting materials.

Table 7 shows the blending ratios of the electrically conductive materials, the coefficients of thermal expansion, and the presence of cracks in the vicinities of the through holes when these electrically conductive materials were used.

Cracks developed to some extent in the boundaries between the through holes and the ceramic material when the difference between the coefficients of thermal expansion of the ceramic material and the electrically conductive material was more than $100 \times 10^{-7}$/°C. However, no cracks developed at all when the coefficient of thermal expansion of the electrically conductive material was so low that the difference between it and the coefficient of thermal expansion of the ceramic material was less than $100 \times 10^{-7}$/°C.

## EP 0 133 010 B1

**Claims**

1. A multilayered ceramic circuit board which comprises a plurality of ceramic layers (5) each having a patterned electrically conductive layer (4) thereon, each ceramic layer (5) being integrally bonded to the adjacent ceramic layer(s) (5) and there being electrically conductive material (3) electrically connecting the conductive layers (4) via through-holes formed in the ceramic layers (5) to create a desired circuit:

wherein the ceramic layers (5) are made from 40 to 70% of a low-temperature softening glass composition and 60 to 30% of an $SiO_2$ containing additive, the low-temperature softening glass composition itself being constituted by 45 to 98% of a glass component and 55 to 2% of a refractory additive (all percentages being by weight) and further characterized in that

(a) the glass component contains 15 to 80% $SiO_2$ and 20 to 60% $B_2O_3$ expressed as a percentage of the glass composition

(b) the glass composition has a softening point in the range 650° to 820°C

(c) the coefficient of thermal expansion of the material of the ceramic layers (5) is less than $70 \times 10^{-7}/°C$ and less than that of the electrically conductive material (3), and its dielectric constant is less than 5.7;

(d) the electrically conductive material (3) is made from a metal having a low resistivity selected from the group consisting of copper, silver, gold and their alloys and mixture thereof, and a filler having a small coefficient of thermal expansion;

(e) the amount of the filler in the electrically conductive material (3) is so selected that the difference between the coefficients of thermal expansion of the material of the ceramic layers (5) and the electrically conductive material (3) is less than $100 \times 10^{-7}/°C$; and

(f) the pitch of the through-holes in the ceramic layers (5) is less than 0.5 mm.

2. A multilayered ceramic circuit board according to claim 1 wherein the filler in the electrically conductive material (3) is selected from low-temperature softening glass compositions for the ceramic layers (5), quartz glass, spodumene, alumina, β-eucryptite and petalite.

3. A multilayered ceramic circuit board according to claim 1 wherein the electrically conductive material (3) is made from 85 to 60% of silver and 15 to 40% of filler selected from quartz glass, spodumene, alumina, β-eucryptite and petalite.

4. A multilayered ceramic circuit board according to claim 1 wherein the electrically conductive material (3) is made from 95 to 70% of copper and 5 to 30% of filler selected from quartz glass, spodumene, alumina, β-eucryptite and petalite.

5. A multilayered ceramic circuit board according to claim 2, wherein the filler for the electrically conductive material (3) is the same low-temperature softening glass composition as that used for the ceramic layers (5).

6. A multilayered ceramic circuit board according to claim 1 wherein the electrically conductive material (3) is made from 80 to 60% of silver and 20 to 40% of the low-temperature softening glass composition for the ceramic layers (5).

7. A multilayered ceramic circuit board according to claim 1 wherein the electrically conductive material (3) is made from 95 to 70% of copper and 5 to 30% of the low-temperature softening glass compositions for the ceramic layers (5).

8. A multilayered ceramic circuit board according to any preceding claim, wherein the $SiO_2$ containing additive for the ceramic layers (5) is selected from quartz, quartz glass, cristobalite, tridymite and any mixture thereof.

9. A multilayered ceramic circuit board according to any preceding claim, wherein the patterned electrically conductive layer (4) is made from the same material as the electrically conductive material (3) in the through holes.

**Patentansprüche**

1. Keramische Mehrschicht-Leiterplatte mit mehreren keramischen Schichten (5), auf deren jeder eine gemusterte elektrisch leitfähige Schicht (4) angeordnet und deren jede mit der oder den benachbarten keramischen Schichten (5) integral verbunden ist, wobei ein elektrisch leitfähiges Material (3) die leitfähigen Schichten (4) über in den keramischen Schichten (5) ausgebildete Durchgangslöcher zur Erzeugung einer gewünschten Schaltung elektrisch verbindet, wobei die keramischen Schichten (5) zu 40 bis 70% aus einer bei niedriger Temperatur erweichenden Glaszusammensetzung und zu 60 bis 30% aus einem $SiO_2$-haltigen Zusatz bestehen, und wobei die Glaszusammensetzung selbst zu 45 bis 98% aus einer glaskomponente und zu 55 bis 2% (alle Prozentangaben in Gewichtsprozent) eines feuerfesten Zusatzes besteht, sowie dadurch gekennzeichnet,

(a) daß die Glaskomponente 15 bis 80% $SiO_2$ und 20 bis 60% $B_2O_3$, bezogen auf die Glaszusammensetzung, enthält.

(b) daß die Glaszusammensetzung einen Erweichungspunkt im Bereich von 650 bis 820°C aufweist,

(c) daß der Wärmeausdehnungskoeffizient des Werkstoffs der keramischen Schichten (5) niedriger ist als $70 \times 10^{-7}/°C$ und niedriger als der des elektrisch leitfähigen Materials (3), und daß seine Dielektrizitätskonstante weniger als 5,7 beträgt,

(d) daß das elektrisch leitfähige Material (3) aus einem niederohmigen Metall, ausgewählt aus Kupfer,

22

## EP 0 133 010 B1

Silber, Gold und deren Legierungen sowie einem Gemisch davon, sowie einem Füllstoff mit geringem Wärmeausdehnungskoeffizient besteht,

(e) daß die Menge an Füllsstoff in dem elektrisch leitfähigen Material (3) so gewählt ist, daß der Unterschied zwischen den Wärmeausdehnungskoeffizienten des Werkstoffs der keramischen Schichten (3) und des elektrisch leitfähigen Materials (3) kleiner ist als $100 \times 10^{-7}/°C$, und

(f) daß der Abstand Durchgangslöcher in den keramischen Schichten (5) weniger als 0,5 mm beträgt.

2. Keramische Mehrschicht-Leiterplatte nach Anspruch 1, wobei der Füllstoff in dem elektrisch leitfähigen Material (3) aus bei niedriger Temperatur erweichenden Glaszusammensetzungen für die keramischen Schichten (5), Quarzglas, Spodumen, Aluminiumoxid, β-Eukryptit und Petalit ausgewählt ist.

3. Keramische Mehrschicht-Leiterplatte nach Anspruch 1, wobie das elektrisch leitfähige Material (3) zu 85 bis 60% aus Silber und zu 15 bis 40% aus Füllstoff, ausgewählt aus Quarzglass, Spodumen, Aluminiumoxid, β-Eukryptit und Petalit, besteht.

4. Keramische Mehrschicht-Leiterplatte nach Anspruch 1, wordurch bei das elektrisch leitfähige Material (3) zu 95 bis 70% aus Kupfer und zu 5 bis 30% aus Füllstoff, ausgewählt aus Quarzglas, Spodumen, Aluminiumoxid. β-Eukryptit und Petalit, besteht.

5. Keramische Mehrschicht-Leiterplatte nach Anspruch 2, wobei der Füllstoff für das elektrisch leitfähige Material (3) die gleiche bei niedriger Temperatur erweichende Glaszusammensetzung ist, wie sie für die keramischen Schichten (5) verwendet wird.

6. Keramische Mehrschicht-Leiterplatte nach Anspruch 1 wobei das elektrisch leitfähige Material (3) zu 80 bis 60% aus Silber und zu 20 bis 40% aus den bei niedriger Temperatur erweichenden Glaszusammensetzungen für die keramischen Schichten (5) besteht.

7. Keramische Mehrschicht-Leiterplatte nach Anspruch 1, wobei das elektrisch leitfähige Material (3) zu 95 bis 70% aus Kupfer und zu 5 bis 30% aus der bei niedriger Temperatur erweichenden Glaszusammensetzung für die keramischen Schichten (5) besteht.

8. Keramische Mehrschicht-Leiterplatte nach einem der vorhergehenden Ansprüche, wobei der $SiO_2$-haltige Zusatz für die keramischen Schichten (5) aus Quarz, Quarzglas, Kristobalit, Tridymit und einem beliebigen Gemisch daraus ausgewählt ist.

9. Keramische Mehrschicht-Leiterplatte nach einem der vorhergehenden Ansprüche, wobei die gemusterte elektrisch leitfähige Schicht (4) aus dem gleichen Material besteht wie das elektrisch leitfähige Material (3) in den Durchgangslöchern.

## Revendications

1. Carte de circuit en céramique à couches multiples, qui comporte une pluralité de couches céramiques (5), sur chacune desquelles est disposée une couche électriquement conductrice structurée (4), chaque couche céramique (5) étant réunie d'un seul tenant à la ou aux couches céramiques adjacentes (5), et un matériau électriquement conducteur (3) raccordant électriquement les couches conductrices (4) par l'intermédiaire de trous transversants ménagés dans les couches céramiques (5) de manière à créer un circuit désiré; et

dans laquelle les couches céramiques (5) sont constituées par 40 à 70% d'une composition de verre se ramollissant aux basses températures et par 60 à 30% d'un additif contenant du $SiO_2$, la composition de verre se ramollissant aux basses températures étant elle-même constituée par 45 à 98% d'un composant de verre et par 55 à 2% d'un additif réfractaire (tous les pourcentages étant indiqués en poids), et en outre caractérisée en ce que

(a) le composant de verre contient 15 à 80% de $SiO_2$ et 20 à 60% de $B_2O_3$, exprimés en pour cent de la composition de verre,

(b) la composition de verre possède un point de ramollissement situé dans la gamme allant de 650° à 820°C,

(c) le coefficient de dilatation thermique du matériau de la couche céramique (5) est inférieur à $70 \times 10^{-7}/°C$ et au coefficient de dilatation thermique du matériau électriquement conducteur (3), et sa constante diélectrique est inférieure à 5,7;

(d) le matériau électriquement conducteur (3) est formé d'un métal possédant une faible résistivité et choisi parmi le groupe incluant le cuivre, l'argent, l'or et leurs alliages et des mélanges de tels matériaux, et d'une charge de remplissage possédant un faible coefficient de dilatation thermique;

(e) la quantité de la charge de remplissage présente dans le matériau électriquement conducteur (3) est choisie de manière que la différence entre les coefficients de dilatation thermique du matériau des couches céramiques (5) et du matériau électriquement conducteur (3) soit inférieur à $100 \times 10^{-7}/°C$; et

(f) le pas de répartition des trous traversants dans les couches céramiques (5) est inférieur à 0,5 mm.

2. Carte de circuit en céramique à couches multiples selon la revendication 1, dans laquelle la charge de remplissage dans le matériau électriquement conducteur (3) est choisie parmi des compositions de verre se ramollissant aux basses températures pour les couches céramiques (5), le verre quartzeux, le spodumène, l'alumine, la β-eucryptite et la pétalite.

3. Carte de circuit en céramique à couches multiples selon la revendicaton 1, dans laquelle le matériau électriquement conducteur (3) est formé par 85 à 60% d'argent et par 15 à 40% d'une charge de remplissage choisie parmit le verre quartzeux, le spodumène, l'alumine, la β-eucryptite et la pétalite.

4. Carte de circuit en céramique à couches multiples selon la revendication 1, dans laquelle le matériau électriquement conducteur (3) est formé par 95 à 70% de cuivre et par 5 à 30% d'une charge de remplissage choisie parmi le verre quartzeux, le spodumène, l'alumine, la β-eucryptite et la pétalite.

5. Carte de circuit en céramique à couches multiples selon la revendication 2, dans laquelle la charge de remplissage pour le materiau électroconducteur (3) est la même composition de verre se ramollissant aux basses températures que celle utilisée pour les couches céramiques (5).

6. Carte de circuit en céramique à couches multiples selon la revendication 1, dans laquelle le matériau électriquement conducteur (3) est formé par 80 à 60% d'argent et par 20 à 40% des compositions de verre se ramollissant aux basses températures, utilisées pour les couches céramiques (5).

7. Carte de circuit en céramique à couches multiples selon la revendication 1, dans laquelle la matériau électriquement conducteur (3) est formé par 95 à 70% de cuivre et par 5 à 30% de la composition de verre se ramollissant aux basses températures, utilisée pour les couches céramiques (5).

8. Carte de circuit en céramique à couches multiples selon l'une quelconque des revendications précédentes, dans laquelle l'additif contenant du $SiO_2$ pour les couches céramiques (5) est choisi parmi le quartz, le verre quartzeux, la crystobalite, la tridymite et n'importe quel mélange de ces matériaux.

9. Carte de circuit en céramique à couches multiples selon l'une quelconque des revendications précédentes, dans laquelle la couche électriquement conductrice structurée (4) est formée par le même matériau que le matériau électriquement conducteur (3) présent dans les trous traversants.

## FIG. 1

## FIG. 2